# EUROPEAN PATENT APPLICATION

(11) **EP 4 219 144 A1**
(43) Date of publication of application: **02.08.2023**
(21) Application number: 21872027.4
(22) Date of filing: 16.08.2021
(51) Int. Cl.: B32B 9/00, B32B 7/022, C23C 14/08, C23C 14/58, G02B 5/20, H01L 51/50, H05B 33/04

(54) **GAS BARRIER FILM AND WAVELENGTH CONVERSION SHEET**

(30) Priority: 24.09.2020 JP 2020159598
(71) Applicant: TOPPAN INC., Tokyo 110-0016 (JP)
(72) Inventor: FUKUGAMI Miki, Tokyo 110-0016 (JP); YASUTAKE Shigekazu, Tokyo 110-0016 (JP); FURUTA Kaoru, Tokyo 110-0016 (JP)
(74) Representative: Hoffmann Eitle
(86) International application number: PCT/JP2021/029913
(87) International publication number: WO 2022/064895

(57) **Abstract**

A gas barrier film according to an aspect of the present disclosure includes, in this order: a substrate; a first AlOₓ-deposited layer; a gas barrier intermediate layer; a second AlOₓ-deposited layer; and a gas barrier coating layer, each of the first and second AlOₓ-deposited layers having a thickness of 15 nm or less, each of the gas barrier intermediate layer and the gas barrier coating layer having a thickness of 200 to 400 nm, the gas barrier coating layer having a first complex modulus of 7 to 11 GPa at a measurement temperature of 25°C and a second complex modulus of 5 to 8 GPa at a measurement temperature of 60°C, the first and second complex moduli being measured by nanoindentation.

## Description

### [Technical Field]

The present invention relates to gas barrier films and wavelength conversion sheets.

### [Background Art]

Gas barrier films are used in, for example, display devices such as organic EL displays and QD liquid crystal displays, which employ quantum dots, and solar cells, to prevent deterioration in quality due to water vapor, oxygen, and the like (see PTL 1 to 3).

### [Citation List]

### [Patent Literature]

PTL 1: JP 2016-006789 A
PTL 2: JP 2010-272761 A
PTL 3: JP 2018-013724 A

### [Summary of Invention]

### [Technical Problem]

Gas barrier films used for the above purpose are required to have not only gas barrier properties but also transparency. In QD liquid crystal displays, for example, quantum dots (QD) are used in a wavelength conversion layer for converting light emitted from blue LEDs into white light; each of the entire front and rear surfaces of the wavelength conversion layer is laminated with a gas barrier film because quantum dots easily deteriorate. In this case, the color of emitted light to be converted changes according to the degree of transparency of the gas barrier film, in particular according to any yellowness thereof; accordingly, such gas barrier films are required to have reduced yellowness. Further, wrinkling of gas barrier films used for the above purpose is required to be suppressed to provide a good appearance, from the viewpoint of improving the transparency, suppressing color non-uniformity, and the like.

The present disclosure has been made in view of the above circumstances; an object thereof is to provide gas barrier films that exhibit good water vapor barrier properties, have reduced yellowness, and for which wrinkling is suppressed, and wavelength conversion sheets including the same.

### [Solution to Problem]

To achieve the above object, the present disclosure provides a gas barrier film including, in this order:
a substrate;
a first AlOₓ-deposited layer;
a gas barrier intermediate layer;
a second AlOₓ-deposited layer; and
a gas barrier coating layer,
each of the first and second AlOₓ-deposited layers having a thickness of 15 nm or less,
each of the gas barrier intermediate layer and the gas barrier coating layer having a thickness of 200 to 400 nm,
the gas barrier coating layer having a first complex modulus of 7 to 11 GPa at a measurement temperature of 25°C and a second complex modulus of 5 to 8 GPa at a measurement temperature of 60°C, the first and second complex moduli being measured by nanoindentation.

According to the above gas barrier film, by having the above laminate structure, with each layer having a thickness within the above ranges, and the gas barrier coating layer satisfying the conditions of the above complex moduli, good oxygen and water vapor barrier properties, reduction in yellowness, and suppression of wrinkling can be achieved. In addition, by setting the thickness of the first and second AlOₓ-deposited layers to 15 nm or less and setting the thickness of the gas barrier intermediate layer and gas barrier coating layer to 200 to 400 nm, reflection and interference at interfaces between the gas barrier intermediate layer and gas barrier coating layer and the first and second AlOₓ-deposited layers can be reduced in the wavelength region of blue LEDs (300 to 400 nm) that has a particularly strong effect on the conversion efficiency of the wavelength conversion sheet. Further, by separately providing the first and second AlOₓ-deposited layers and the gas barrier intermediate layer and gas barrier coating layer, each layer can be thin, which suppresses the occurrence of wrinkling and cracking, and layers imparting gas barrier properties can have a sufficient total thickness, which provides good gas barrier properties. Moreover, setting the complex modulus of the gas barrier coating layer to within the above ranges can provide oxygen and water vapor barrier properties and deformation resistance during deformation of the substrate due to heat treatment or the like.

In the above gas barrier film, the hardness of the gas barrier coating layer, as measured by nanoindentation, is 1.15 to 1.70 GPa at a measurement temperature of 25°C and 0.85 to 1.30 GPa at a measurement temperature of 60°C. With the gas barrier coating layer satisfying the conditions of the above hardness, better oxygen and water vapor barrier properties, further reduction in yellowness, and further suppression of wrinkling can be achieved.

In the above gas barrier film, the surface of the substrate facing the first AlOₓ-deposited layer is preferably subjected to plasma treatment. By using the substrate having a surface that faces the first AlOₓ-deposited layer and has been subjected to plasma treatment, the adhesion between the substrate and the first AlOₓ-deposited layer is improved, which suppresses delamination between these layers. Further, by using the substrate having a surface that faces the first AlOₓ-deposited layer and has been subjected to plasma treatment, the adhesion between these layers is improved by plasma treatment, without the formation of a layer for improving the adhesion, such as an anchor coat layer; thus, light transmission properties are improved compared with the case where an anchor coat layer or the like is provided.

In the above gas barrier film, the gas barrier coating layer is preferably a layer formed using a composition for forming the gas barrier coating layer, the composition containing at least one member selected from the group consisting of hydroxyl group-containing polymer compounds, metal alkoxides, silane coupling agents, and hydrolysates thereof. With the composition for forming the gas barrier coating layer containing the above component, the complex modulus and hardness of the gas barrier coating layer can be easily controlled to within the above ranges, and better oxygen and water vapor barrier properties can be obtained. Further, among the above components, when a hydroxyl group-containing polymer compound and a hydrolysate of a metal alkoxide are used in combination, strong hydrogen bonding occurs between a hydroxyl group of the hydroxyl group-containing polymer compound and a hydroxyl group of the hydrolysate of the metal alkoxide, resulting in even better gas barrier properties.

The present disclosure also provides a wavelength conversion sheet including a phosphor layer and at least one gas barrier film of the present disclosure that is arranged to face at least one of major surfaces of the phosphor layer.

### [Advantageous Effects of Invention]

The present disclosure provides gas barrier films that exhibit good water vapor barrier properties, have reduced yellowness, and for which wrinkling is suppressed, and wavelength conversion sheets including the same.

### [Brief Description of Drawings]

Fig. 1 is a schematic cross-sectional view illustrating an embodiment of a gas barrier film.
Fig. 2 is a schematic cross-sectional view illustrating an embodiment of a wavelength conversion sheet.

### [Description of Embodiments]

With reference to the drawings, embodiments of the present disclosure will be described in detail below. Note that the same or equivalent elements are denoted by the same reference characters in the drawings, and redundant description thereof is omitted.

### [Gas barrier film]

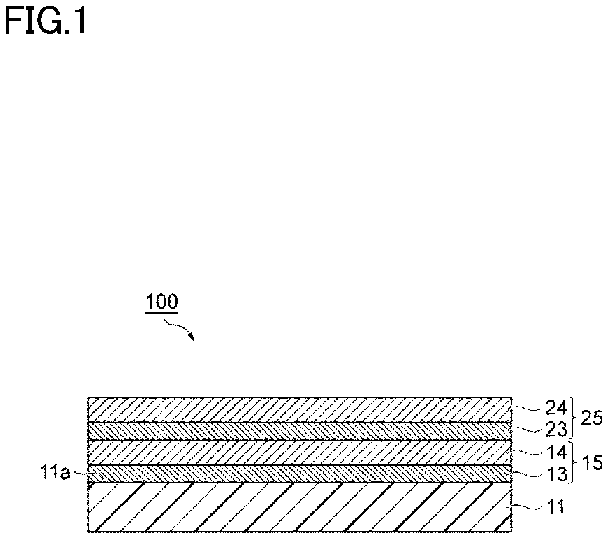

Fig. 1 is a schematic cross-sectional view illustrating an embodiment of a gas barrier film of the present disclosure. A gas barrier film 100 according to the present embodiment includes a substrate 11, a first AlOₓ-deposited layer 13 provided on the substrate 11, a gas barrier intermediate layer 14 provided on the first AlOₓ-deposited layer 13, a second AlOₓ-deposited layer 23 provided on the gas barrier intermediate layer 14, and a gas barrier coating layer 24 provided on the second AlOₓ-deposited layer 23. The gas barrier film 100 includes a first barrier layer 15 composed of the first AlOₓ-deposited layer 13 and gas barrier intermediate layer 14, and a second barrier layer 25 composed of the second AlOₓ-deposited layer 23 and the gas barrier coating layer 24.

### [Substrate 11]

The substrate 11 is preferably a polymer film. Non-limiting examples of the material of the polymer film include polyesters such as polyethylene terephthalate, polybutylene terephthalate, and polyethylene naphthalate; polyamides such as nylon; polyolefins such as polypropylene and cycloolefin; polycarbonate; and triacetyl cellulose. The polymer film is preferably a polyester film, a polyamide film, or a polyolefin film, more preferably a polyester film or a polyamide film, and even more preferably a polyethylene terephthalate film. A polyethylene terephthalate film is desirable from the viewpoint of transparency, processability, and adhesion. Further, the polyethylene terephthalate film is preferably a biaxially oriented polyethylene terephthalate film from the viewpoint of transparency and gas barrier properties.

If necessary, the substrate 11 may contain additives such as an antistatic agent, an ultraviolet absorber, a plasticizer, and a slip agent. Further, an anchor coat layer may be provided on the surface 11a of the substrate 11 facing the first AlOₓ-deposited layer 13. The anchor coat layer may be made of a resin selected from, for example, polyester resins, isocyanate resins, urethane resins, acrylic resins, polyvinyl alcohol resins, ethylene vinyl alcohol resins, vinyl-modified resins, epoxy resins, oxazoline group-containing resins, modified styrene resins, modified silicone resins, alkyl titanate, and the like. The anchor coat layer may be formed of the above-mentioned resins used singly or in combination of two or more as a composite resin. The anchor coat layer has a thickness of, for example, 0.001 µm or more and 2 µm or less. In particular, with a substrate film having an anchor coat layer (adhesion-enhancing layer) formed in-line during formation of the substrate 11, followed by stretching of the film, the anchor coat layer can have a very small thickness (e.g., 0.02 µm or less), resulting in reduced energy losses in the anchor coat layer.

Further, the surface 11a of the substrate 11 facing the first AlOₓ-deposited layer 13 may be subjected to surface treatment such as corona treatment, flame treatment, or plasma treatment. In particular, compared with the case where an anchor coat layer or the like is provided, directly providing the AlOₓ-deposited layer 13 on the surface-treated surface prevents energy losses that would be caused in the anchor coat layer or the like, thus improving light transmission properties. As plasma treatment, reactive ion etching described below is preferable.

The substrate 11 may include a modified layer formed by subjecting the surface 11a thereof to reactive ion etching (hereinafter also referred to as "RIE"). The modified layer refers to a portion of the substrate 11 that is located at the surface thereof and has been modified to be layered by RIE treatment.

In the RIE treatment, plasma is used. Radicals or ions generated in plasma exert a chemical effect of imparting functional groups to the surface of the substrate 11. Further, ion etching produces a physical effect of removing surface impurities and increasing surface roughness. Thus, the modified layer exhibiting the above chemical and physical effects due to the RIE treatment improves adhesion between the substrate 11 and the first AlOₓ-deposited layer 13, so that separation does not easily occur between the substrate 11 and the first AlOₓ-deposited layer 13 even under a high-temperature and high-humidity environment.

The RIE treatment may be applied to the substrate 11 using a known RIE plasma treatment apparatus. The plasma treatment apparatus is preferably a roll-to-roll in-line plasma treatment apparatus. The roll-to-roll in-line plasma treatment apparatus may be a planar plasma treatment apparatus, a hollow anode plasma treatment apparatus, or the like.

The thickness of the substrate 11 is not particularly limited; it is preferably 3 µm or more and 100 µm or less, and more preferably 5 µm or more and 50 µm or less. Setting the thickness of the substrate 11 to 3 µm or more facilitates processing, whereas setting the thickness of the substrate 11 to 100 µm or less reduces the total thickness of the gas barrier film.

### [First AlOₓ-deposited layer 13 and second AlOₓ-deposited layer 23]

In the present embodiment, the first AlOₓ-deposited layer 13 is formed on the substrate 11 by vapor deposition. Further, the second AlOₓ-deposited layer 23 is formed on the gas barrier intermediate layer 14 by vapor deposition. Each of the first AlOₓ-deposited layer 13 and the second AlOₓ-deposited layer 23 is a layer containing AlOx (aluminum oxide). AlOx is preferable because it has high transparency and can easily reduce yellowness. Here, the value of x is preferably 0.01 to 2.00, and more preferably 1.00 to 1.90, from the viewpoint of easily obtaining good gas barrier properties and easily reducing yellowness. The first AlOₓ-deposited layer 13 and second AlOₓ-deposited layer 23 may have the same configuration or different configurations.

Examples of the vacuum deposition method used in forming the first AlOₓ-deposited layer 13 and second AlOₓ-deposited layer 23 include a resistance heating-type vacuum deposition method, an electron-beam heating-type vacuum deposition method, and an induction heating-type vacuum deposition method.

The thickness of the first AlOₓ-deposited layer 13 and second AlOₓ-deposited layer 23 is 15 nm or less, and preferably 13 nm or less. Setting the maximum thickness of these layers to not more than the above value can improve transparency of the gas barrier film and thus reduce yellowness. On the other hand, the thickness of the first AlOₓ-deposited layer 13 and second AlOₓ-deposited layer 23 is preferably 5 nm or more, and more preferably 8 nm or more. Setting the minimum thickness of these layers to not less than the above value can provide better gas barrier properties.

### [Gas barrier intermediate layer 14 and gas barrier coating layer 24]

In the present embodiment, the gas barrier intermediate layer 14 and gas barrier coating layer 24 are provided to prevent various types of secondary damage in subsequent processes, and to impart high gas barrier properties. The gas barrier intermediate layer 14 and gas barrier coating layer 24 may have the same configuration or different configurations.

Each of the gas barrier intermediate layer 14 and gas barrier coating layer 24 is preferably a layer formed using a composition containing at least one member selected from the group consisting of hydroxyl group-containing polymer compounds, metal alkoxides, silane coupling agents, and hydrolysates thereof. The gas barrier intermediate layer 14 and gas barrier coating layer 24 having such a configuration can be formed using a composition (hereinafter also referred to as "coating solution") having, as a main ingredient, an aqueous solution or water/alcohol mixed solution containing at least one member selected from the group consisting of hydroxyl group-containing polymer compounds, metal alkoxides, silane coupling agents, and hydrolysates thereof. From the viewpoint of further improving gas barrier properties, the coating solution preferably contains at least a silane coupling agent or a hydrolysate thereof, more preferably contains, in addition to a silane coupling agent or a hydrolysate thereof, at least one member selected from the group consisting of hydroxyl group-containing polymer compounds, metal alkoxides, and hydrolysates thereof, and even more preferably contains a hydroxyl group-containing polymer compound or a hydrolysate thereof, a metal alkoxide or a hydrolysate thereof, and a silane coupling agent or a hydrolysate thereof. For example, the coating solution may be prepared by mixing a metal alkoxide and a silane coupling agent or hydrolysates thereof into a solution in which a hydroxyl group-containing polymer compound as a water-soluble polymer is dissolved in an aqueous (water or water/alcohol mixture) solvent.

The respective components contained in the coating solution for forming the gas barrier intermediate layer 14 and gas barrier coating layer 24 will be described in detail. Examples of the hydroxyl group-containing polymer compound used for the coating solution include polyvinyl alcohol, polyvinyl pyrrolidone, starch, methyl cellulose, carboxymethyl cellulose, and sodium alginate. Among them, polyvinyl alcohol (hereinafter "PVA") is preferable because particularly good gas barrier properties are exhibited when it is used in the coating solution for the gas barrier intermediate layer 14 and gas barrier coating layer 24.

From the viewpoint of obtaining good gas barrier properties, the gas barrier intermediate layer 14 and gas barrier coating layer 24 are preferably formed from a composition containing at least one member selected from the group consisting of the metal alkoxide represented by the following general formula (1) and the hydrolysate thereof.

M(OR¹)ₘ(R²)ₙ₋ₘ ... (1)

In formula (1), R¹ and R² are each independently a monovalent organic group having 1 to 8 carbon atoms, and are preferably an alkyl group such as a methyl group or an ethyl group. M represents an n-valent metal atom such as Si, Ti, Al, or Zr. Further, m represents an integer from 1 to n. Note that, when a plurality of R¹ or R² are present, the plurality of R¹ or R² may be the same as or different from each other.

Specific examples of the metal alkoxide include tetraethoxysilane [Si(OC₂H₅)₄] and triisopropoxyaluminum [Al(O-2'-C₃H₇)₃]. Tetraethoxysilane and triisopropoxyaluminum are preferable because they are relatively stable in an aqueous solvent after hydrolysis.

An example silane coupling agent is a compound represented by general formula (2) below. Use of the silane coupling agent represented by general formula (2) further improves water resistance and heat resistance of the gas barrier film.

Si(OR¹¹)ₚ(R¹²)₃₋ₚR¹³ ... (2)

In general formula (2), R¹¹ represents an alkyl group such as a methyl group or an ethyl group; R¹² represents a monovalent organic group such as an alkyl group, an aralkyl group, an aryl group, an alkenyl group, an alkyl group having a substituent acryloxy group, or an alkyl group having a substituent methacryloxy group; R¹³ represents a monovalent organic functional group; and p represents an integer from 1 to 3. Note that, when a plurality of R¹¹ or R¹² are present, the plurality of R¹¹ or R¹² may be the same as or different from each other. An example of the monovalent organic functional group represented by R¹³ is a monovalent organic functional group containing a glycidyloxy group, an epoxy group, a mercapto group, a hydroxyl group, an amino group, an alkyl group having a substituent halogen atom, or an isocyanate group.

Specific examples of the silane coupling agent include vinyltrimethoxysilane, γ-chloropropylmethyldimethoxysilane, γ-chloropropyltrimethoxysilane, 3-glycidoxypropylmethyldimethoxysilane, 3-glycidoxypropyltrimethoxysilane, 3-glycidoxypropylmethyldiethoxysilane, 3-glycidoxypropylmethyltriethoxysilane, γ-methacryloxypropyltrimethoxysilane, and γ-methacryloxypropylmethyldimethoxysilane.

Further, the silane coupling agent may be an oligomer made by polymerization of the compound represented by general formula (2). The oligomer is preferably a trimer, and more preferably 1,3,5-tris(3-trialkoxysilylalkyl)isocyanurate. This is a product made by condensation polymerization of 3-isocyanate alkyl alkoxysilane. This 1,3,5-tris(3-trialkoxysilylalkyl)isocyanurate has no chemical reactivity in the isocyanate moiety, but is known for ensuring reactivity by the polarity of the isocyanurate moiety. Generally, as with 3-isocyanate alkyl alkoxysilane, 1,3,5-tris(3-trialkoxysilylalkyl)isocyanurate is added to an adhesive or the like, and is known as an adhesion improving agent. Therefore, by adding 1,3,5-tris(3-trialkoxysilylalkyl)isocyanurate to a hydroxyl group-containing polymer compound, the water resistance of the gas barrier intermediate layer 14 and gas barrier coating layer 24 can be improved by hydrogen bonding. Whereas 3-isocyanate alkyl alkoxysilane has high reactivity and low liquid stability, 1,3,5-tris(3-trialkoxysilylalkyl)isocyanurate is easily dispersed in an aqueous solution, and the viscosity can be stably maintained, although the isocyanurate ring moiety of 1,3,5-tris(3-trialkoxysilylalkyl)isocyanurate is not water soluble due to the polarity. In addition, the water resistance of 1,3,5-tris(3-trialkoxysilylalkyl)isocyanurate is equivalent to that of 3-isocyanate alkyl alkoxysilane.

Some 1,3,5-tris(3-trialkoxysilylalkyl)isocyanurate is produced by thermal condensation of 3-isocyanatepropylalkoxysilane and may contain 3-isocyanatepropylalkoxysilane of the base material; however, this poses no particular problem. Further, 1,3,5-tris(3-trialkoxysilylpropyl)isocyanurate is more preferable, and 1,3,5-tris(3-trimethoxysilylpropyl)isocyanurate is even more preferable. 1,3,5-tris(3-trimethoxysilylpropyl)isocyanurate is practically advantageous because this methoxy group has a fast hydrolysis rate, and those including a propyl group can be obtained at a comparatively low price.

If necessary, the coating solution may contain an isocyanate compound or a known additive such as a dispersant, a stabilizer, or a viscosity modifier to the extent that does not impair the gas barrier properties.

The coating solution for forming the gas barrier intermediate layer 14 and gas barrier coating layer 24 may be applied using, for example, a dip coating method, a roll coating method, a gravure coating method, a reverse gravure coating method, an air knife coating method, a comma coating method, a die coating method, a screen printing method, a spray coating method, an offset gravure printing method, or the like. The coating formed by applying this coating solution may be dried using, for example, a hot-air drying method, a hot-roll drying method, a high-frequency application method, an infrared irradiation method, a UV irradiation method, or a combination thereof.

The above coating may be dried at a temperature of, for example, 50°C to 150°C, and preferably 70°C to 100°C. Setting the temperature for this drying process to within the above range further suppresses the occurrence of cracking in the first AlOₓ-deposited layer 13 and second AlOₓ-deposited layer 23 or the gas barrier intermediate layer 14 and gas barrier coating layer 24, thus enabling exhibition of good gas barrier properties.

The thickness of the gas barrier intermediate layer 14 and gas barrier coating layer 24 after curing is 200 nm to 400 nm, preferably 230 nm to 380 nm, and more preferably 250 nm to 350 nm. Setting the maximum thickness of these layers to not more than the above value can improve transparency of the gas barrier film, thus reduce yellowness, and suppress the occurrence of wrinkling in the gas barrier intermediate layer 14 and gas barrier coating layer 24. On the other hand, setting the minimum thickness of these layers to not less than the above value can provide good gas barrier properties.

The total thickness of the gas barrier intermediate layer 14 and gas barrier coating layer 24 is preferably 400 nm to 800 nm, and more preferably 450 nm to 600 nm. Further, the thicknesses of the gas barrier intermediate layer 14 and gas barrier coating layer 24 may be different from each other. The ratio of the thickness of the gas barrier intermediate layer 14 to the thickness of the gas barrier coating layer 24 (thickness of gas barrier intermediate layer 14/thickness of gas barrier coating layer 24) may be 1.0 to 2.0, more than 1.0 and 2.0 or less, or 1.1 to 1.5. Forming the gas barrier coating layer 24 at a thickness less than or equal to that of the gas barrier intermediate layer 14 further facilitates suppression of wrinkling in the gas barrier coating layer 24 and increasing the hardness thereof.

In the present embodiment, the complex modulus of the gas barrier coating layer 24, as measured by nanoindentation, is 7 to 11 GPa at a measurement temperature of 25°C and 5 to 8 GPa at a measurement temperature of 60°C. Further, the hardness of the gas barrier coating layer 24, as measured by nanoindentation, is 1.15 to 1.70 GPa at a measurement temperature of 25°C and 0.85 to 1.30 GPa at a measurement temperature of 60°C. The complex modulus and hardness of the gas barrier coating layer 24 can be adjusted, for example, by controlling the crosslink density based on the composition of the above-described coating solution (in particular, the amount of silane coupling agent) or the heating temperature during formation of the layer.

In the present specification, the above complex modulus and hardness of the gas barrier coating layer 24 indicate the respective complex modulus and hardness calculated by nanoindentation. Nanoindentation is a measurement method in which quasi-static indentation testing is performed on a measurement target, to obtain mechanical properties of a sample. The complex modulus and hardness can be measured using, for example, the apparatus below.

As a measurement apparatus, Hysitron TI Premier (trade name) (available from Bruker Japan K.K.) having a nanoDMA III transducer (trade name) mounted thereto as a transducer is used. As an indenter, a TI-0283 (trade name) is used which is a Berkovich-type heating diamond indenter with a tip having an included angle of 142.3°. The measurement temperature is controlled using an xSol 400 (trade name), which is a heating stage available from Bruker Japan K.K.. The rate of temperature increase during temperature control is 20°C/min; after the heating stage reaches a desired temperature, this temperature is maintained for 10 minutes, followed by measurement. In addition, fused quartz serving as a reference material is tested in advance, and the relationship between the contact depth and the projected contact area is calibrated. Measurement conditions for nanoindentation are such that, according to quasi-static testing, indentation is performed at a loading rate of 30 nm/sec until a depth of 30 nm is reached, and a load at the maximum depth is maintained for 1 second, followed by unloading at a rate of 30 nm/sec. By analyzing the result of an unloading curve in the region at loads 60 to 95% relative to the maximum load during unloading, the complex modulus and hardness are calculated using the Oliver-Pharr method.

The complex modulus of the gas barrier coating layer 24, as measured by nanoindentation, is 7 to 11 GPa at a measurement temperature of 25°C, and preferably 7.5 to 10.5 GPa at the same measurement temperature. Further, the complex modulus of the gas barrier coating layer 24, as measured by nanoindentation, is 5 to 8 GPa at a measurement temperature of 60°C, and preferably 5.5 to 7.5 GPa at the same measurement temperature. When the maximum value of each complex modulus is less than or equal to the upper limit of the above corresponding range, occurrence of wrinkles in the gas barrier coating layer 24 can be suppressed, and when the minimum value of each complex modulus is greater than or equal to the lower limit of the above corresponding range, good gas barrier properties can be obtained.

The hardness of the gas barrier coating layer 24, as measured by nanoindentation, is preferably 1.15 to 1.70 GPa at a measurement temperature of 25°C, and more preferably 1.20 to 1.65 GPa at the same measurement temperature. Further, the hardness of the gas barrier coating layer 24, as measured by nanoindentation, is preferably 0.85 to 1.30 GPa at a measurement temperature of 60°C, and more preferably 0.90 to 1.30 GPa at the same measurement temperature. When the maximum value of each hardness is less than or equal to the upper limit of the above corresponding range, occurrence of wrinkles in the gas barrier coating layer 24 can be further suppressed, and when the minimum value of each hardness is greater than or equal to the lower limit of the above corresponding range, better gas barrier properties can be obtained.

Although a preferred embodiment of the gas barrier film of the present disclosure has been described, it should be understood that the gas barrier film of the present disclosure is not limited to the embodiment described above. The gas barrier film may or may not include another layer between the substrate 11 and first AlOₓ-deposited layer 13, between the first AlOₓ-deposited layer 13 and gas barrier intermediate layer 14, between the gas barrier intermediate layer 14 and second AlOₓ-deposited layer 23, or between the second AlOₓ-deposited layer 23 and gas barrier coating layer 24. If the gas barrier film does not include another layer, the above respective layers are in direct contact with each other. The gas barrier film may include another barrier layer in addition to the first and second barrier layers 15 and 25. However, a larger number of laminated barrier layers more easily reduce the transparency; and wrinkling or curling is more likely to occur in the gas barrier film as the number of times heating is performed for layer formation increases. Accordingly, the gas barrier film preferably includes only the first and second barrier layers 15 and 25 as barrier layers. The gas barrier film may further include a matt layer below.

### [Matt layer]

A matt layer is provided on the outermost surface of the gas barrier film to allow exhibition of one or more optical and/or antistatic functions. For example, in the case where the gas barrier film is used for protection of the phosphor layer in the wavelength conversion sheet, the matt layer is provided on the opposite surface of the gas barrier film to that facing the phosphor layer. Examples of the optical functions include, but are not limited to, a function of preventing interference fringes (moire), an antireflection function, and a diffusing function. Among them, the matt layer preferably has at least an interference fringe prevention function as an optical function. In the present embodiment, a description will be provided of the case where the matt layer has at least an interference fringe prevention function.

The matt layer may be composed of a binder resin and microparticles. The microparticles may be embedded in the binder resin so as to be partially exposed from the surface of the matt layer and thus form fine asperities on that surface. By providing such a matt layer on the surface of the barrier film, generation of interference fringes such as Newton's rings can be more reliably prevented; consequently, a wavelength conversion sheet with high efficiency, high definition, and long life can be obtained.

The binder resin may be, but is not limited to, a resin having excellent optical transparency. Specific examples of this resin include thermoplastic resins, thermosetting resins, and ionizing radiation curable resins, such as polyester resins, acrylic resins, acrylic urethane resins, polyester acrylate resins, polyurethane acrylate resins, urethane resins, epoxy resins, polycarbonate resins, polyamide resins, polyimide resins, melamine resins, and phenolic resins. Other than an organic resin, a silica binder can also be used. Among them, it is preferable to use an acrylic resin or a urethane resin because of there being a wide range of options for these materials, and it is more preferable to use an acrylic resin because of its good light resistance and optical properties. These may be used singly or in a combination of two or more.

Examples of the microparticles include, but are not limited to, inorganic microparticles such as silica, clay, talc, calcium carbonate, calcium sulfate, barium sulfate, titanium oxide, and alumina; and organic microparticles such as styrene resin, urethane resin, silicone resin, acrylic resin, and polyamide resin. Among them, the microparticles are preferably made of silica, acrylic resin, urethane resin, polyamide resin, or the like, with a refractive index of 1.40 to 1.55 considering the transmittance. Microparticles with a low refractive index are expensive, whereas microparticles with an excessively high refractive index tend to impair the transmittance. These may be used singly or in a combination of two or more.

The mean particle size of the microparticles is preferably 0.1 to 30 µm, and more preferably 0.5 to 10 µm. When the mean particle size of the microparticles is 0.1 µm or more, an excellent interference fringe prevention function tends to be obtained, and when it is 30 µm or less, the transparency tends to be further improved.

The content of the microparticles in the matt layer is preferably 0.5 to 30% by mass, and more preferably 3 to 10% by mass, relative to the total amount of the matt layer. When the content of the microparticles is 0.5% by mass or more, the light diffusing function and the interference fringe prevention function tend to be further improved, and when the content thereof is 30% by mass or less, reduction in luminance is prevented.

The matt layer can be formed by application of a coating liquid containing a binder resin and microparticles described above, followed by drying and curing thereof. The coating liquid may be applied using a gravure coater, a dip coater, a reverse coater, a wire-bar coater, a die coater, or the like.

The thickness of the matt layer is preferably 0.1 to 20 µm, more preferably 0.3 to 10 µm. When the thickness of the matt layer is 0.1 µm or more, a uniform film and thus a sufficient optical function tend to be easily obtained. On the other hand, when the thickness of the matt layer is 20 µm or less, and microparticles are used in the matt layer, the unevenness imparting effect tends to be easily obtained due to these microparticles being exposed at the surface of the matt layer.

The gas barrier film of the present embodiment having the above-described configuration can be used for applications that require barrier properties related to the transmission of oxygen and water vapor. The gas barrier film of the present embodiment is useful, for example, for packaging materials for food, medicine, and the like, color conversion sheets for backlights of liquid crystal displays such as QD liquid crystal displays, which employ quantum dots, sealing members for organic electroluminescent (organic EL) displays, color conversion sheets for organic EL lighting, and protective sheets for solar cells; it is particularly suitable for use in a color conversion sheet for a backlight of a liquid crystal display.

### [Wavelength conversion sheet]

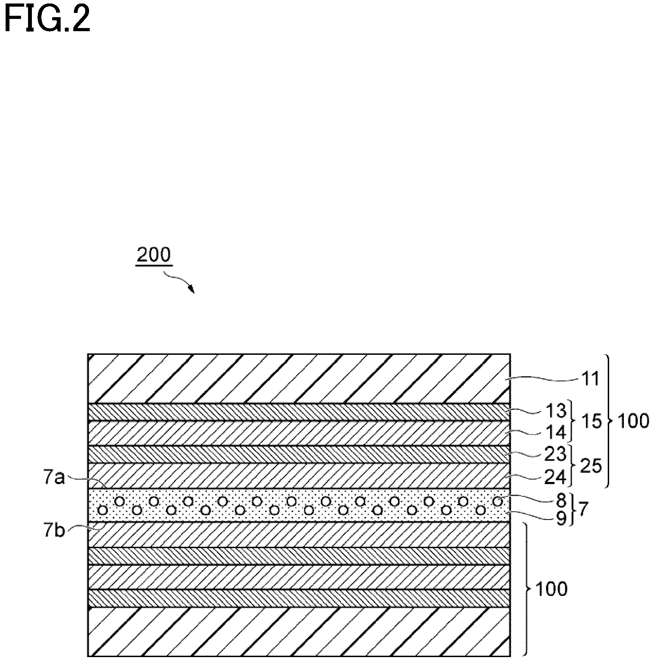

Fig. 2 is a schematic cross-sectional view illustrating an embodiment of the wavelength conversion sheet of the present disclosure. The wavelength conversion sheet shown in Fig. 2 contains phosphors, such as quantum dots, and can be used, for example, in a backlight unit for LED wavelength conversion.

The wavelength conversion sheet 200 shown in Fig. 2 generally includes a phosphor layer (wavelength conversion layer) 7 containing phosphors, and a gas barrier film 100 provided on each of one surface 7a of the phosphor layer 7 and the other surface 7b thereof. This provides a structure in which the phosphor layer 7 is enclosed (i.e., sealed) between the gas barrier films 100 and 100. Here, the structure in which the phosphor layer 7 is sandwiched between the pair of gas barrier films 100 and 100 is preferable because it is necessary to impart gas barrier properties to the phosphor layer 7. Each of the layers constituting the wavelength conversion sheet 200 will be described in detail below.

### [Gas barrier film]

The gas barrier film 100 shown in Fig. 1 can be used as the pair of gas barrier films 100 and 100. In the wavelength conversion sheet 200, the gas barrier film 100 disposed on one surface 7a of the phosphor layer 7 and the gas barrier film 100 disposed on the other surface 7b may be the same or different.

The pair of gas barrier films 100 and 100 may be disposed such that the respective gas barrier coating layers 24 face the phosphor layer 7 as shown in Fig. 2 or that the respective substrates 11 face the phosphor layer 7. From the viewpoint of even further suppressing deterioration of the phosphor layer 7 due to oxygen and water vapor, the pair of gas barrier films 100 and 100 are preferably disposed such that the respective gas barrier coating layers 24 face the phosphor layer 7. The respective gas barrier coating layers 24 may be in direct contact with the phosphor layer 7. To increase the adhesion between the respective gas barrier coating layers 24 and the phosphor layer 7, a primer layer may be provided on each of the gas barrier coating layers 24. Each gas barrier film 100 may be used as a laminate film having another film (e.g., a polyethylene terephthalate film) attached thereto with an adhesive. Further, each gas barrier film 100 may be a laminate of two or more gas barrier films 100.

### [Phosphor Layer]

The phosphor layer 7 is a thin film containing a sealing resin 9 and phosphors 8 and having a thickness of several tens to several hundreds of µm. The sealing resin 9 can be, for example, a photosensitive resin or a thermosetting resin. One or more types of phosphors 8 are sealed in a mixed state in the sealing resin 9. When the phosphor layer 7 and the pair of gas barrier films 100 and 100 are laminated, the sealing resin 9 plays a role of bonding them together and filling gaps therebetween. Moreover, the phosphor layer 7 may be composed of two or more laminated phosphor layers each having only one type of phosphor 8 sealed therein. For two or more types of phosphors 8 used in these one or more phosphor layers, those having the same excitation wavelength are selected. The excitation wavelength is selected based on the wavelength of light emitted from an LED light source. The fluorescent colors of two or more types of phosphors 8 are different from each other. When blue LEDs (peak wavelength: 450 nm) are used as the LED light source, and two types of phosphors 8 are used, their fluorescent colors are preferably red and green. Each fluorescence wavelength and the wavelength of light emitted from the LED light source are selected based on the spectral characteristics of the color filter. The fluorescence peak wavelength may be, for example, 650 nm for red, and 550 nm for green.

Next, the particle structure of the phosphors 8 is described. The phosphors 8 are preferably quantum dots, which have high color purity and show promise for improvement in luminance. Examples of quantum dots include those in which a core serving as a light-emitting part is coated with a shell serving as a protective film. An example of the core is cadmium selenide (CdSe) or the like, and an example of the shell is zinc sulfide (ZnS) or the like. The quantum efficiency is improved due to the surface defects of the CdSe particles being covered with ZnS having a large bandgap. Moreover, the phosphors 8 may be those in which a core is doubly coated with a first shell and a second shell. In this case, CdSe may be used for the cores, zinc selenide (ZnSe) may be used for the first shell, and ZnS may be used for the second shell. In addition, YAG:Ce or the like may be used as phosphors 8 other than quantum dots.

The mean particle size of the phosphors 8 is preferably 1 to 20 nm. The thickness of the phosphor layer 7 is preferably 1 to 500 µm.

The content of the phosphors 8 in the phosphor layer 7 is preferably 1 to 20 mass%, and more preferably 3 to 10 mass%, relative to the total amount of the phosphor layer 7.

Examples of the sealing resin 9 include thermoplastic resins, thermosetting resins, ultraviolet-curing resins, and the like. These resins can be used singly or in a combination of two or more.

Examples of thermoplastic resins include cellulose derivatives, such as acetyl cellulose, nitrocellulose, acetyl butyl cellulose, ethyl cellulose, and methyl cellulose; vinyl-based resins, such as vinyl acetate and copolymers thereof, vinyl chloride and copolymers thereof, and vinylidene chloride and copolymers thereof; acetal resins, such as polyvinyl formal and polyvinyl butyral; acrylic-based resins, such as acrylic resins and copolymers thereof, and methacrylic resins and copolymers thereof; polystyrene resins; polyamide resins; linear polyester resins; fluororesins; and polycarbonate resins.

Examples of thermosetting resins include phenolic resins, urea melamine resins, polyester resins, silicone resins, and the like.

Examples of ultraviolet-curing resins include photopolymerizable prepolymers, such as epoxy acrylate, urethane acrylate, and polyester acrylate. Such a photopolymerizable prepolymer can be used as a main component, and a monofunctional or multifunctional monomer can be used as a diluent.

### [Examples]

Although the present disclosure will be described in detail below with reference to Examples, the present disclosure is not limited to them.

### [Examples 1 to 6 and Comparative Examples 1 to 6]

### [Production of gas barrier film]

A biaxially oriented polyethylene terephthalate film having a thickness of 12 µm was prepared as a substrate. A planar plasma treatment apparatus was used to form a modified layer on one surface of the substrate by RIE treatment. Next, a first AlOₓ-deposited layer was formed on the modified layer. The first AlOₓ-deposited layer was formed by vacuum deposition of aluminum oxide on the modified layer. Specifically, using a vacuum deposition apparatus that employs an electron beam heating method, aluminum metal was evaporated while oxygen gas was introduced to the apparatus. Thus, a first AlOₓ-deposited layer having a predetermined thickness was formed. Then, a gas barrier intermediate layer, a second AlOₓ-deposited layer, and a gas barrier coating layer were formed in this order. The second AlOₓ-deposited layer was formed using the same method as that for the first AlOₓ-deposited layer. As the gas barrier intermediate layer and gas barrier coating layer, the coats A and B below were used according to the respective Examples and Comparative Examples. By completing the above process, a gas barrier film having the substrate, first AlOₓ-deposited layer, gas barrier intermediate layer, second AlOₓ-deposited layer, and gas barrier coating layer laminated in this order was obtained.

### [Coat A]

The liquids A, B, and C below were mixed to prepare a solution containing these liquids in the following ratio: liquid A/liquid B/liquid C = 70/20/10 (solid content mass ratio); and this solution was applied and dried by gravure coating to thereby form a gas barrier intermediate layer or a gas barrier coating layer at a predetermined thickness.

### [Coat B]

The liquids A and B below were mixed to prepare a solution containing these liquids in the following ratio: liquid A/liquid B = 70/30 (solid content mass ratio); and this solution was applied and dried by gravure coating to thereby form a gas barrier intermediate layer or a gas barrier coating layer at a predetermined thickness.
Liquid A: Hydrolyzed solution with a solid content of 5 mass% (in terms of SiO₂) obtained by adding 72.1 g of hydrochloric acid (0.1 N) to 17.9 g of tetraethoxysilane and 10 g of methanol, followed by stirring for 30 minutes for hydrolysis
Liquid B: Water/methanol = 95/5 (mass ratio) solution containing 5 mass% polyvinyl alcohol
Liquid C: Hydrolyzed solution obtained by diluting 1,3,5-tris(3-trialkoxysilylpropyl)isocyanurate with water/isopropyl alcohol solution (mass ratio between water and isopropyl alcohol is 1:1) so that it has a solid content of 5 mass%

### [Example 7]

A gas barrier film was obtained in the same manner as Example 1, except that the substrate used was a 12-µm-thick biaxially oriented polyethylene terephthalate film with a 0.005-µm-thick anchor coat layer made from an aliphatic polyurethane resin and laminated on a surface on the side where barrier layers were to be laminated, and thus RIE treatment was not performed.

Table 1 shows coat types used in the respective Examples and Comparative Examples, drying temperatures and times for formation of gas barrier intermediate layers and gas barrier coating layers, thicknesses of first and second AlOₓ-deposited layers (in the table, these are collectively referred to as "Deposited layer"), and thicknesses of gas barrier intermediate layers and gas barrier coating layers (in the table, these are collectively referred to as "Coat layer"). Heat drying of the gas barrier intermediate layer and gas barrier coating layer was performed such that Heat Label (available from MICRON Corp.) was attached to the surface of the coating before drying, and that an oven temperature and a line speed were adjusted to cause the temperature of the coating when checked after drying to have a desired value and to provide a desired drying time. The drying temperatures shown in Table 1 indicate the temperatures of the above Heat Label.

**[Table 1]**

| | Coat type | Drying temperature (°C) | Drying time (sec) | Thickness (nm) | |
|---|---|---|---|---|---|
| | | | | Deposited layer | Coat layer |
| Ex. 1 | A | 80 | 4 | 8 | 230 |
| Ex. 2 | A | 80 | 4 | 5 | 230 |
| Ex. 3 | A | 80 | 4 | 13 | 230 |
| Ex. 4 | A | 80 | 4 | 8 | 380 |
| Ex. 5 | A | 65 | 4 | 8 | 230 |
| Ex. 6 | A | 95 | 5 | 8 | 230 |
| Ex. 7 | A | 80 | 4 | 8 | 230 |
| Comp. Ex. 1 | A | 60 | 3.5 | 8 | 230 |
| Comp. Ex. 2 | A | 80 | 4 | 8 | 405 |
| Comp. Ex. 3 | A | 80 | 4 | 9 | 180 |
| Comp. Ex. 4 | A | 115 | 5 | 8 | 230 |
| Comp. Ex. 5 | A | 80 | 4 | 18 | 230 |
| Comp. Ex. 6 | B | 80 | 4 | 8 | 230 |

### <Measurement of complex modulus and hardness>

For the gas barrier films obtained in the Examples and Comparative Examples, the complex modulus and hardness of the gas barrier coating layer were measured using the following method. The measurement apparatus used was Hysitron TI Premier (trade name) (available from Bruker Japan K.K.) having a nanoDMA III transducer (trade name) mounted thereto as a transducer. The indenter used was a TI-0283 (trade name), which is a Berkovich-type heating diamond indenter with a tip having an included angle of 142.3°. The measurement temperature was controlled using an xSol 400 (trade name), which is a heating stage available from Bruker Japan K.K.. The rate of temperature increase during temperature control was 20°C/min; after the heating stage had reached a desired temperature, this temperature was maintained for 10 minutes, followed by measurement. In addition, fused quartz serving as a reference material was tested in advance, and the relationship between the contact depth and the projected contact area was calibrated. Measurement conditions for nanoindentation were such that, according to quasi-static testing, indentation was performed at a loading rate of 30 nm/sec until a depth of 30 nm was reached, and a load at the maximum depth was maintained for 1 second, followed by unloading at a rate of 30 nm/sec. By analyzing the result of an unloading curve in the region at loads 60 to 95% relative to the maximum load during unloading, the complex modulus and hardness were calculated using the Oliver-Pharr method. The results of these are shown in Table 2.

### <Measurement of b*>

The color coordinate b* in the L*a*b* color system of each gas barrier film obtained in the Examples and Comparative Examples was measured using a colorimeter (trade name: Colour Cute i, available from Suga Test Instruments Co., Ltd.) under the conditions: illuminant C with a 2 degree field of view. When b* was 0.5 or less, yellowness was determined to be reduced. The results are shown in Table 2.

### <Measurement of water vapor transmission rate (WVTR)>

The water vapor transmission rate of each gas barrier film obtained in the Examples and Comparative Examples was measured using the following method. First, a 25-µm-thick polyethylene terephthalate film and the surface of the gas barrier coating layer of each gas barrier film obtained in the Examples and Comparative Examples were bonded to each other with an acrylic urethane resin adhesive, to produce laminate films. The water vapor transmission rate of each laminate film was measured using a water vapor transmission rate measuring apparatus (PERMATRAN-W 3/34, available from MOCON Inc.) under the conditions: temperature of 40°C and relative humidity of 90%. The measurement was performed on the laminate films in the initial state, and the laminate films stored for 1,000 hours at a temperature of 60°C and a relative humidity of 90%. The measuring method was in accordance with JIS K-7126, method B (equal-pressure method), and the measured values were expressed in units of [g/m²/day]. Note that the same measurement was performed three times, and the average value was adopted. The results are shown in Table 2.

### <Appearance Evaluation>

The surface of the gas barrier coating layer of each gas barrier film obtained in the Examples and Comparative Examples was visually observed, and the appearance was evaluated based on the following evaluation criteria. The results are shown in Table 2.
A: Almost no wrinkling and thus neat
B: Slight but inconspicuous wrinkling
C: Many deep wrinkles and thus poor

**[Table 2]**

| | Complex modulus (GPa) | | Hardness (GPa) | | b* (%) | WVTR (g/m²/day) | | Appearance |
|---|---|---|---|---|---|---|---|---|
| | 25°C | 60°C | 25°C | 60°C | | 0h | 1000h | |
| Ex. 1 | 8.5 | 5.8 | 1.25 | 0.95 | -0.1 | 0.06 | 0.7 | A |
| Ex. 2 | 8.5 | 5.7 | 1.26 | 0.94 | -0.4 | 0.06 | 0.9 | A |
| Ex. 3 | 8.2 | 5.5 | 1.23 | 0.90 | 0.1 | 0.05 | 0.4 | A |
| Ex. 4 | 8.6 | 5.7 | 1.30 | 0.98 | 0.3 | 0.05 | 0.4 | B |
| Ex. 5 | 7.3 | 5.2 | 1.17 | 0.86 | -0.6 | 0.07 | 0.9 | A |
| Ex. 6 | 10.7 | 7.8 | 1.65 | 1.28 | -0.1 | 0.04 | 0.7 | B |
| Ex. 7 | 8.5 | 5.8 | 1.25 | 0.95 | 0.0 | 0.08 | 0.9 | A |
| Comp. Ex. 1 | 6.5 | 4.8 | 1.13 | 0.83 | -0.5 | 0.13 | 1.5 | A |
| Comp. Ex. 2 | 9.1 | 6.2 | 1.35 | 0.99 | 0.8 | 0.07 | 0.4 | C |
| Comp. Ex. 3 | 8.2 | 5.5 | 1.22 | 0.90 | 0.1 | 0.10 | 1.5 | A |
| Comp. Ex. 4 | 11.5 | 8.5 | 1.72 | 1.33 | -0.1 | 0.04 | 0.6 | C |
| Comp. Ex. 5 | 8.5 | 5.8 | 1.25 | 0.95 | 0.6 | 0.04 | 0.4 | A |
| Comp. Ex. 6 | 6.7 | 4.8 | 0.75 | 0.58 | 0.0 | 0.03 | 5.1 | A |

### [Reference Signs List]

- 7: Phosphor layer
- 8: Phosphor
- 9: Sealing resin
- 11: Substrate
- 13: First AlOₓ-deposited layer
- 14: Gas barrier intermediate layer
- 15: First barrier layer
- 23: Second AlOₓ-deposited layer
- 24: Gas barrier coating layer
- 25: Second barrier layer
- 100: Gas barrier film
- 200: Wavelength conversion sheet

## Claims

1. A gas barrier film comprising, in this order:
a substrate;
a first AlOₓ-deposited layer;
a gas barrier intermediate layer;
a second AlOₓ-deposited layer; and
a gas barrier coating layer,
each of the first and second AlOₓ-deposited layers having a thickness of 15 nm or less,
each of the gas barrier intermediate layer and the gas barrier coating layer having a thickness of 200 to 400 nm,
the gas barrier coating layer having a first complex modulus of 7 to 11 GPa at a measurement temperature of 25°C and a second complex modulus of 5 to 8 GPa at a measurement temperature of 60°C, the first and second complex moduli being measured by nanoindentation.

2. The gas barrier film according to claim 1, wherein:
the gas barrier coating layer has a first hardness of 1.15 to 1.70 GPa at a measurement temperature of 25°C and a second hardness of 0.85 to 1.30 GPa at a measurement temperature of 60°C, the first and second hardnesses being measured by nanoindentation.

3. The gas barrier film according to claim 1 or 2, wherein:
the substrate has a surface facing the first AlOₓ-deposited layer, the surface of the substrate being subjected to plasma treatment.

4. The gas barrier film according to any one of claims 1 to 3, wherein:
the gas barrier coating layer is a layer formed using a composition for forming the gas barrier coating layer, the composition containing at least one member selected from the group consisting of hydroxyl group-containing polymer compounds, metal alkoxides, silane coupling agents, and hydrolysates thereof.

5. A wavelength conversion sheet comprising:
a phosphor layer; and
at least one gas barrier film according to any one of claims 1 to 4, the at least one gas barrier film being arranged to face at least one of major surfaces of the phosphor layer.
